Europäisches Patentamt

European Patent Office

Office européen des brevets

(19)

(11) Numéro de publication: **0 207 826
B1**

## FASCICULE DE BREVET EUROPEEN

(12)

(45) Date de publication du fascicule du brevet:
**23.05.90**

(21) Numéro de dépôt: **86401120.0**

(22) Date de dépôt: **27.05.86**

(51) Int. Cl.⁵: **H04N 5/335,** H04N 5/33,
H01L 27/14

(54) Dispositif de détection avec retard et intégration en phase.

(30) Priorité: **30.05.85 FR 8508165
27.09.85 FR 8514376**

(43) Date de publication de la demande:
**07.01.87 Bulletin 87/2**

(45) Mention de la délivrance du brevet:
**23.05.90 Bulletin 90/21**

(84) Etats contractants désignés:
**DE FR GB NL SE**

(56) Documents cités:
**FR-A- 2 554 955
US-A- 4 327 377**

**PATENTS ABSTRACTS OF JAPAN,
vol. 5, no. 181 (E-83)[853], 20 novembre 1981;
JP-A-56 109 076 (FUJITSU K.K.) 29-08-1981**

(73) Titulaire: **THOMSON-CSF, 51, Esplanade du Général de
Gaulle, F-92800 Puteaux(FR)**

(72) Inventeur: **Munier, Bernard, Thomson-CSF
SCPI 19, avenue de Messine, F-75008 Paris(FR)**

(74) Mandataire: **Mayeux, Michèle et al, THOMSON-CSF
SCPI, F-92045 PARIS LA DEFENSE CEDEX 67(FR)**

## Description

La présente invention concerne un dispositif de détection avec retard et intégration en phase.

Selon l'art antérieur, on connaît de tels dispositifs qui comportent généralement plusieurs barrettes linéaires de détecteurs, parallèles les unes aux autres. Il y a un mouvement relatif entre les détecteurs et l'image à analyser, c'est-à-dire que les détecteurs d'une même ligne reçoivent de façon séquentielle un même point de l'image à analyser. On somme en synchronisme avec le défilement les informations recueillies sur les différents détecteurs.

Ce type de dispositif est connu dans la littérature anglosaxonne sous le nom de "Time Delay Integration" ou TDI. Il permet de multiplier le temps d'intégration par un facteur N égal au nombre de détecteurs de chaque ligne. Comme les bruits de lecture s'ajoutent de façon quadratique, on obtient un gain sur le rapport signal sur bruit égal à $\sqrt{N}$. Le brevet FR-A 2 554 955 décrit un tel dispositif de l'art antérieur.

Dans l'art antérieur, on dispose généralement entre chaque ligne de détecteurs un régistre à décalage à transfert de charge, dont les entrées latérales reçoivent les signaux délivrés par les détecteurs d'une même ligne. Ce registre assure l'addition en synchronisme des signaux des détecteurs d'une même ligne.

Le problème qui se pose est que ces registres à entrées latérales, placés entre les lignes de détecteurs, sont très encombrants.

Ce problème est particulièrement critique lorsque le dispositif de détection est utilisé dans l'infra-rouge. Dans ce domaine spectral, le flux de photons reçu par le dispositif est considérable et il en est de même du nombre de charges électriques à véhiculer dans chaque registre. On est donc conduit à augmenter la largeur des registres pour pouvoir stocker toutes les charges.

La présente invention permet de résoudre ce problème.

Selon l'invention, on n'utilise plus de registres à entrées latérales placés entre les lignes de détecteurs. On utilise pour chaque ligne de détecteurs un dispositif à transfert de charge qui est relié par une seule connexion, ou éventuellement par deux connexions, aux détecteurs ce qui permet de placer ce dispositif, hors de la zone photosensible, ailleurs qu'entre les ligne de détecteurs. Ainsi, on dispose de plus de place au niveau de la zone photosensible ce qui permet par exemple d'augmenter le temps d'intégration des charges, ou d'augmenter la résolution, et donc d'améliorer les performances du dispositif.

D'autre part, dans l'art antérieur, les registres à décalages à entrées latérales placés entre les lignes de détecteurs adoptaient le même pas pour leurs étages que le pas entre détecteurs. Selon l'invention, les dispositifs à transfert de charge ne sont plus placés entre les lignes de détecteurs ce qui permet de fixer le pas de leurs étages sans tenir compte du pas entre détecteurs. Dans certains cas, on peut être amené à utiliser un pas de 25 micromètres entre étages du dispositif alors que le pas entre les détecteurs est de 100 micromètres. On diminue ainsi la longueur des dispositifs à transfert de charge, donc leur encombrement. L'efficacité de transfert se trouve améliorée.

La présente invention concerne un dispositif de détection photoélectrique avec retard et intégration en phase comportant des détecteurs disposés selon des lignes et des colonnes sur un substrat semi-conducteur, des moyens de stockage des charges étant associés à chaque détecteur, et les détecteurs d'une même ligne recevant de façon séquentielle un même point de l'image, des moyens retardant les informations issues des détecteurs d'une même ligne pour les additionner en synchronisme, caractérisé en ce que:

- un registre à décalage adresse séquentiellement chaque colonne de détecteurs;
- lesdits moyens retardant les informations sont constitués par un dispositif à transfert de charge associé à chaque ligne de détecteurs, qui reçoit séquentiellement sur une même connexion, conformément à l'adressage séquentiel des colonnes par le registre à décalage, les informations stockées par les détecteurs de cette ligne, ces dispositifs à transfert de charge étant positionné en dehors des lignes de détecteurs.

La présente invention concerne un dispositif de détection avec retard et intégration en phase qui peut être utilisé aussi bien dans le spectre visible que pour détecter, par exemple, des rayons X ou un rayonnement infra-rouge.

La description suivante va être effectuée dans le cas particulier de dispositifs sensibles dans l'infra-rouge dans la bande spectrale 8 - 12 micromètres où le problème précédemment énoncé est particulièrement critique.

D'autres objets, caractéristiques et résultats de l'invention ressortiront de la description suivante, donnée à titre d'exemple non limitatif et illustrée par les figures annexées qui représentent ;

- la figure 1, le schéma d'un mode de réalisation d'un dispositif de détection avec retard et intégration en phase selon l'invention ;
- la figure 2, une vue de dessus d'un mode de réalisation sous forme intégrée des différents éléments associés à chaque détecteur ;
- la figure 3, une vue de dessus d'un mode de réalisation sous forme intégrée du dispositif à transfert de charge associé à chaque ligne de détecteurs ;
- les figures 4a à d, et 6a à e des vues en coupe à travers les dispositifs des figures 2 et 3 et des schémas illustrant le fonctionnement de ces dispositifs ;
- les figures 5a à j, les diagrammes de différents signaux d'horloge appliqués au dispositif selon l'invention ;
- la figure 7, le schéma d'un autre mode de réalisation d'un dispositif de détection avec retard et intégration en phase selon l'invention ;
- la figure 8, une vue de dessus d'un autre mode de réalisation sous forme intégrée du dispositif à transfert de charge associé à chaque ligne de détecteurs ;

- les figures 9a à h, les diagrammes de différents signaux d'horloge appliqués à un mode de réalisation du dispositif selon l'invention.

- la figure 10, le schéma d'un autre mode de réalisation d'un dispositif selon l'invention ;

- la figure 11, une vue de dessus d'un mode de réalisation sous forme intégrée du dispositif à transfert de charge associé à chaque ligne de détecteurs ;

- la figure 12, un schéma partiel d'une variante de réalisation d'un dispositif selon l'invention.

Sur les différentes figures, les mêmes repères désignent les mêmes éléments, mais, pour des raisons de clarté, les cotes et proportions de divers éléments ne sont pas respectées.

Dans les différents schémas, les dispositifs de synchronisation précise, relevant de la technologie courante, n'ont pas été représentés en vue de rendre les dessins plus clairs et de simplifier l'exposé.

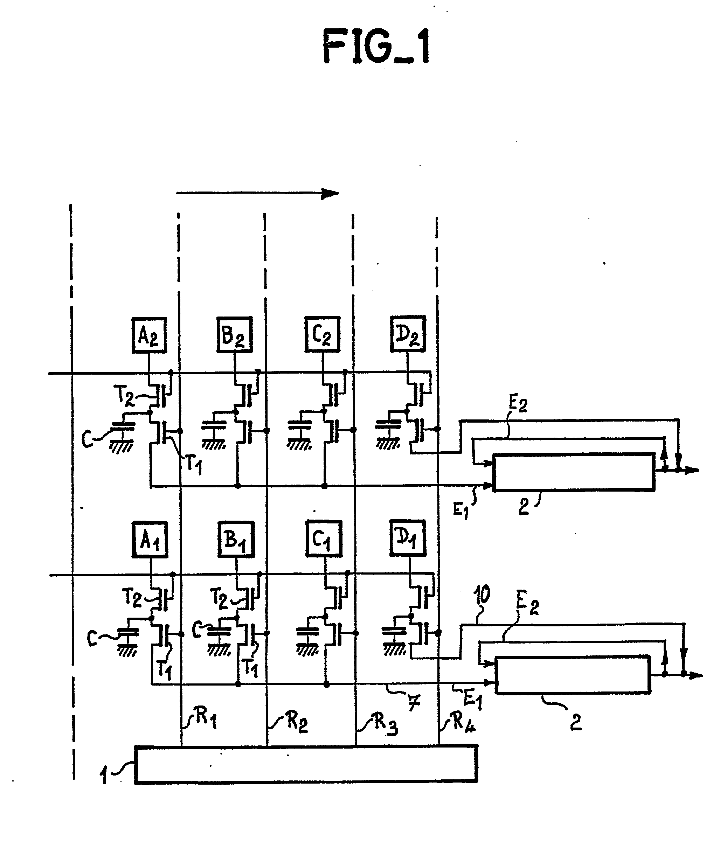

La figure 1 représente de façon schématique un mode de réalisation d'un dispositif de détection avec retard et intégration en phase selon l'invention.

Le dispositif de la figure 1 ne comporte que deux lignes de quatre détecteurs désignés par les références $A_1$, $B_1$, $C_1$, $D_1$ et $A_2$, $B_2$, $C_2$, $D_2$.

Il est bien entendu que le dispositif selon l'invention comporte, de façon concrète, une multitude de lignes, par exemple 200 lignes, chaque ligne comportant de nombreux détecteurs, par exemple 8 détecteurs.

Les détecteurs $A_1$, $B_1$, $C_1$, $D_1$, $A_2$, $B_2$, $C_2$, $D_2$ sont disposés selon des lignes et des colonnes.

Dans le cas de la détection infra-rouge, les détecteurs sont réalisés sur un substrat semi-conducteur différent de celui sur lequel sont réalisés les autres éléments, tels que les éléments portant les références C, $T_1$, $T_2$ et le dispositif 2 sur la figure 1. A titre d'exemple, les détecteurs sont réalisés sur un substrat semiconducteur en Hg Cd Te, alors que le reste du dispositif est réalisé sur un substrat en silicium de type P.

A la partie supérieure de la figure 1, on a indiqué par une flèche, allant de gauche à droite, le sens du défilement relatif de l'image à analyser devant les détecteurs.

Chaque point de l'image à analyser est donc vu successivement par les détecteurs $A_1$, $B_1$, $C_1$ puis $D_1$ pour la ligne inférieure et $A_2$, $B_2$, $C_2$ puis $D_2$ pour la ligne supérieure.

A chaque détecteur sont associés :

- des moyens de stockage des charges symbolisés sur la figure 1 par une capacité C ;

- un élément d'injection des charges des détecteurs dans les capacités C qui est symbolisé par des transistors MOS $T_2$. Ces transistors $T_2$ sont reliés entre un détecteur et une borne de chaque capacité C, l'autre borne de la capacité C étant à la masse ou à un potentiel constant. Les grilles des transistors $T_2$ associés aux détecteurs d'une même ligne sont reliées les unes aux autres et reçoivent une tension de commande qui laisse ces transistors conducteurs pendant au moins une partie du temps de lecture ;

- un élément interrupteur commandé par un registre à décalage 1 qui adresse séquentiellement chaque colonne de détecteurs. Cet élément interrupteur est symbolisé sur la figure 1 par un transistor MOS $T_1$. Ces transistors $T_1$, excepté celui qui est associé au dernier détecteur, sont reliés entre la borne de chaque capacité C qui n'est pas à la masse et une connexion commune aux détecteurs d'une même ligne et reliée à une entrée $E_1$ du dispositif à transfert de charge 2 associé à cette ligne. Les grilles des transistors $T_1$ sont commandées par les sorties $R_1$, $R_2$, $R_3$, $R_4$ du registre 1.

A l'extérieur de la zone photosensible, c'est-à-dire hors de la zone des détecteurs, on trouve les dispositifs à transfert de charge 2 associés à chaque ligne de détecteurs.

Pour diminuer l'encombrement on peut disposer les dispositifs à transfert de charge 2 en quinconce.

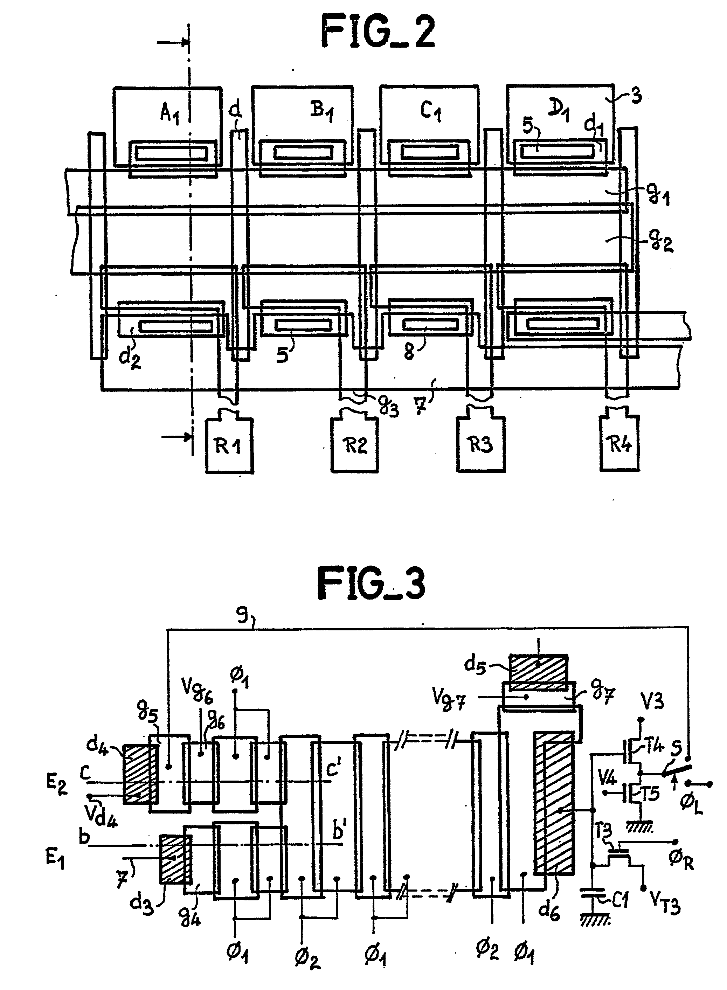

Le fonctionnement de ces dispositifs sera expliqué de façon détaillée avec la description des figures 2 à 6.

On voit sur la figure 1 que chaque dispositif à transfert de charge 2 a sa sortie reliée à une deuxième entrée $E_2$. On ré-injecte ainsi dans le dispositif l'information précédemment reçue d'un détecteur en phase avec celle reçue du détecteur suivant de la même ligne. On constate aussi sur la figure 1 que l'information provenant des détecteurs $D_1$ et $D_2$ est reliée directement à la sortie des dispositifs à transfert de charge 2 associés à chaque ligne de détecteurs.

La figure 2 est une vue de dessus d'un mode de réalisation sous forme intégrée des différents éléments reliés à chaque détecteur et qui sont représentés symboliquement sur la figure 1 par les transistors MOS $T_1$ et $T_2$ et la capacité C.

Sur la figure 2, on n'a représenté que les éléments reliés aux détecteurs $A_1$, $B_1$, $C_1$ et $D_1$ de la figure 1.

En haut de la figure 2, on a représenté des contacts métalliques 3 reliés aux détecteurs $A_1$, $B_1$, $C_1$ et $D_1$ qui ne sont pas représentés. A titre de repérage, on a inscrit la référence des détecteurs sur le contact métallique auquel chaque détecteur est relié. Dans le cas d'un rayonnement infra-rouge, ces détecteurs sont en général des photo-diodes.

Chaque contact 3 est relié à une diode $d_1$ intégrée dans un substat semi-conducteur 4 grâce à une ouverture 5 réalisée dans l'isolant 6 protégeant la surface du substrat semi-conducteur.

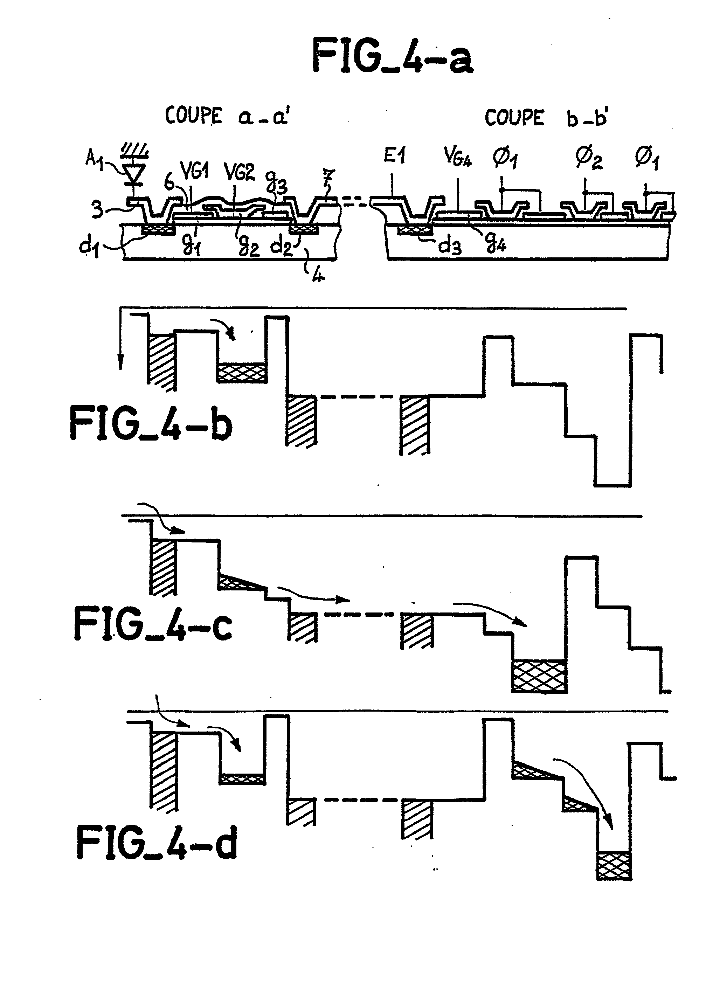

La figure 4a - partie gauche - est une vue en coupe selon l'axe a a' indiqué sur la figure 2 où sont représentés les éléments 3, 4, 6, $d_1$ dont il vient d'être question.

A la suite des diodes $d_1$, on trouve deux grilles $G_1$ et $G_2$ qui reçoivent des tensions de polarisation constantes $V_{G1}$ et $V_{G2}$, puis des grilles $G_3$ qui comme on le voit sur la figure 2 sont propres à chaque détecteur. Les grilles $G_3$ d'une même colonne sont reliées entre elles. Des zones d'isolement d assurent le transfert des charges provenant d'un détecteur donné sous les grilles $G_1$ et $G_2$, puis sous la grille $G_3$ propre à ce détecteur.

Il est possible d'utiliser des tensions de polarisation $V_{G1}$ et $V_{G2}$ pulsées.

Par exemple, on peut adapter le temps d'intégration des charges en cas de suréclairement en faisant passer la tension $V_{G1}$ au niveau bas.

De même, on peut faire passer la tension $V_{G2}$ au niveau bas pour améliorer le transfert des charges.

Les grilles $G_3$ sont commandées par les sorties $R_1$, $R_2$, $R_3$, $R_4$ du registre 1.

Après les grilles $G_3$, on trouve une diode $d_2$ associée à chaque détecteur. Une connexion 7 relie, grâce à des ouvertures 8 à travers la couche d'oxyde 6, les diodes $d_2$ associées aux détecteurs d'une même ligne, à une entrée $E_1$ du dispositif à transfert de charge 2 associé à cette ligne de détecteurs. Seule la diode $d_2$ associée au dernier détecteur $D_1$ n'est pas reliée à la connexion 7 mais se trouve reliée directement à la sortie du dispositif à transfert de charge 2.

La figure 3 est une vue de dessus d'un mode de réalisation sous forme intégrée du dispositif à transfert de charge 2 associé à chaque ligne de détecteurs.

La figure 3 représente un mode de réalisation du dispositif 2 utilisant un procédé connu d'injection des charges dans un dispositif à transfert de charge. On peut utiliser diverses variantes du dispositif 2 en modifiant la façon dont sont injectées les charges ce qui entraîne de légères modifications de structures.

Comme on l'a vu sur la figure 1, ce dispositif comporte deux entrées $E_1$ et $E_2$. Les figures 4a - partie droite - et 6a sont des vues en coupe selon les axes b b' et c c' qui montrent la structure des entrées du dispositif 2.

Les entrées $E_1$ et $E_2$ comportent respectivement une diode $d_3$ et $d_4$ chacune suivie par une série de grilles de capacités MOS.

La diode $d_3$ est reliée à la connexion 7. Elle est suivie par une grille $G_4$ portée à un potentiel constant $V_{G4}$.

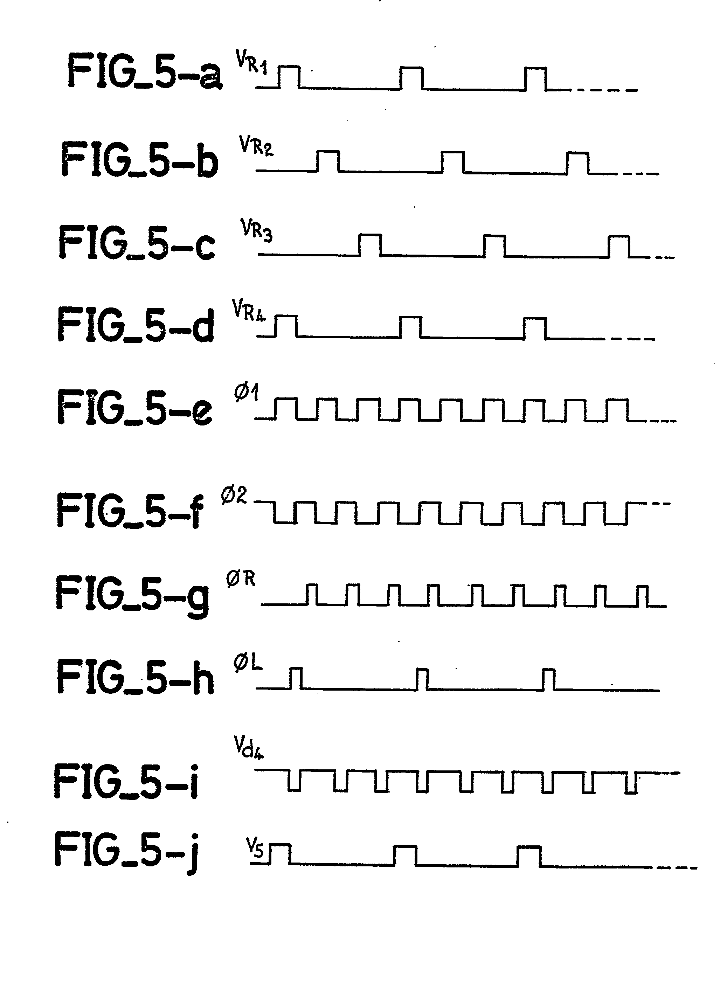

La diode $d_4$ reçoit une tension de polarisation $V_{d4}$, pulsée et représentée sur la figure 5i. Elle est suivie par une grille $G_5$ qui reçoit par la connexion 9 la tension de sortie du dispositif 2, et par une grille $G_6$ qui reçoit une tension de polarisation constante $V_{G6}$.

On voit sur la figure 3 qu'après les grilles $G_4$, $G_5$ et $G_6$, les deux entrées $E_1$ et $E_2$ comportent encore un couple de grilles propre à chaque entrée et ensuite des couples de grilles situées sur un seul canal où débouchent les charges provenant des deux entrées $E_1$ et $E_2$. Ces couples de grilles reçoivent des signaux d'horloge en opposition de phase $\emptyset_1$ et $\emptyset_2$ représentés sur les figures 5e et f.

Le dispositif à transfert de charge représenté sur la figure 3 comporte également une diode de sortie $d_6$, reliée à un étage de lecture comportant une capacité de lecture $C_1$, un transistor MOS de remise à zéro $T_3$ de la capacité qui reçoit un signal d'horloge $\emptyset_R$ représenté sur la figure 5g et une tension de polarisation constante $V_{T3}$. La diode de sortie $d_6$ est également reliée à un dispositif de lecture des charges constitué de deux transistors MOS $T_4$ et $T_5$ montés en suiveur qui délivrent un signal de sortie S.

Ce signal de sortie S peut être ré-injecté vers l'entré $E_2$ par l'intermédiaire de la connexion 9 ou envoyé vers la sortie du dispositif.

Cette alternative est symbolisée sur la figure 3 par un interrupteur qui reçoit le signal d'horloge $\emptyset_L$ représenté sur la figure 5h.

Le dispositif à transfert de charge 2 de la figure 3 comporte également une diode $d_5$ suivie par une grille $G_7$ à un potentiel constant $V_{G7}$ qui permet l'injection de charges provenant du dernier détecteur $D_1$.

On a pris comme exemple dans la description le cas d'un substrat de type P, auquel l'on applique des tensions de commande qui lorsqu'elles sont au niveau haut sont positives.

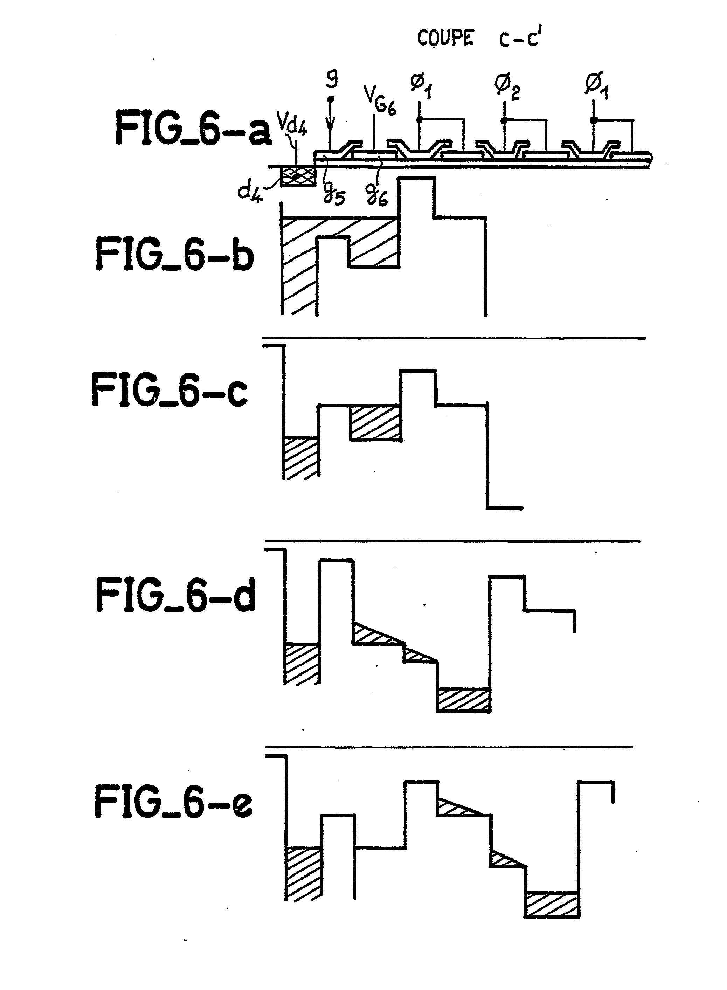

Les figures 4b à d et 6b à e illustrent le fonctionnement du dispositif selon l'invention et représentent les potentiels dans le substrat semi-conducteur à différents instants.

La figure 4b montre l'intégration sous la grille $G_2$ de charges provenant du détecteur $D_1$. Les charges injectées à travers la diode $d_1$ traversent le canal situé sous la grille $G_1$ et s'accumulent dans un puits de stockage situé sous la grille $G_2$.

La figure 4c montre le transfert des charges stockées sous la grille $G_2$ dans le dispositif à transfert de charge. Ce transfert est déclenché par la modification du potentiel appliqué à la grille $G_3$ reliée à la sortie $R_1$ du registre 1 et qui reçoit la tension $V_{R1}$. Sur les figures 5a à d, on a représenté les tensions sur les sorties $R_1$ à $R_4$ du registre 1. Le passage de $R_1$ au niveau haut permet le transfert des charges vers la diode $d_3$ et la grille $G_4$.

Le passage au niveau haut de $\emptyset_1$ permet le transfert de ces charges vers le reste du dispositif 2.

Sur la figure 4d, $\emptyset_2$ est au niveau haut et $\emptyset_1$ est au niveau bas. Il y a transfert des charges sous un couple d'électrodes relié à $\emptyset_2$.

La figure 6b représente les potentiels dans le substrat à un instant où le signal $V_{d4}$ est au niveau bas. La grille $G_5$ reçoit par la connexion 9 le signal disponible en sortie du dispositif 2. Le signal $\emptyset_1$ est au niveau bas.

La figure 6c représente les potentiels à un instant où le signal $V_{d4}$ est au niveau haut.

La quantité de charge stockée sous la grille $G_6$ est directement fonction du signal transmis par la connexion 9.

La figure 6d représente les potentiels dans le substrat à un instant où le signal d'horloge $\emptyset_1$ est au niveau haut. Les charges stockées sous la grille $G_6$ sont transférées sous un couple d'électrodes recevant le signal $\emptyset_2$, puis sous un couple d'électrodes recevant le signal $\emptyset_1$ - voir la figure 6e.

Sur les figures 5a à i, on a représenté les tensions $V_{R1}$, $V_{R2}$, $V_{R3}$, $V_{R4}$ disponibles sur les sorties $R_1$ à $R_4$ du registre 1, puis les signaux d'horloge $\emptyset_1$ et $\emptyset_2$ qui commandent le transfert dans les dispositifs à transfert de charge 2, les signaux $\emptyset_R$ et $\emptyset_L$

appliqués en sortie des registres 2 et le signal $V_{d4}$ appliqué à la diode $d_4$.

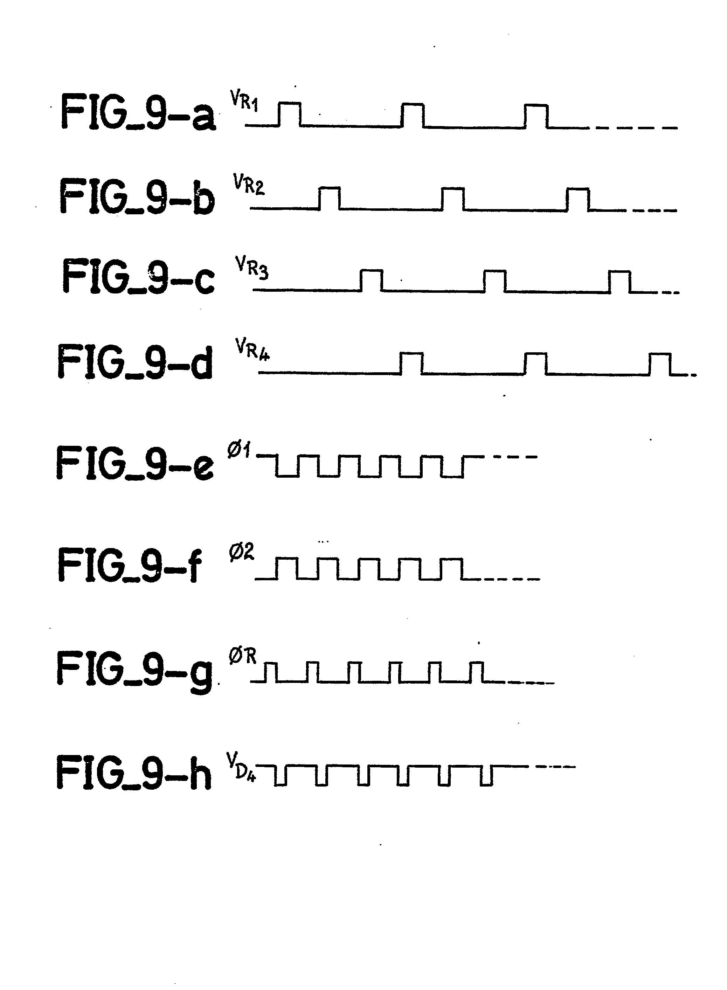

Il faut signaler que sur les figures 5a à i comme sur les figures 9a à h, les tensions varient entre un niveau haut et un niveau bas qui peuvent correspondre à des valeurs différentes.

On constate que les signaux $V_{R1}$ et $V_{R4}$ sont confondus. Cela provient du fait que les signaux issus des derniers détecteurs $D_1$, $D_2$, $D_3$... ne transitent pas par le dispositif à transfert de charge. Il est donc possible, alors que les signaux issus de ces détecteurs sont envoyés vers la sortie du registre, d'envoyer vers l'entrée $E_1$ du registre les signaux issus des premiers détecteurs $A_1$, $A_2$, $A_3$...

Le signal $\emptyset_L$ qui est représenté sur la figure 5h, lorsqu'il est au niveau bas, produit le transfert du signal S sur la connexion 9 de façon à ce que ce signal soit ré-injecté vers l'entrée $E_2$.

Lorsque les signaux issus des détecteurs $A_1$, $B_1$, $C_1$ ont été retardés et sommés dans le dispositif à transfert de charge 2, le signal $\emptyset_L$ passe au niveau haut. Ce passage de $\emptyset_L$ au niveau haut a lieu alors que le signal $V_{R4}$ est passé du niveau haut au niveau bas. On dispose alors sur la diode $d_5$ du signal provenant du détecteur $D_1$ et sur la diode $d_6$ des signaux cumulés des détecteurs $A_1$, $B_1$, $C_1$, $D_1$ pour le même point de l'image. Le signal S résultant est transmis vers l'extérieur du dispositif à transfert de charge.

Le signal $\emptyset/_R$ qui est représenté sur la figure 5g passe au niveau haut après le passage de $\emptyset_L$ au niveau bas.

Pour obtenir un fonctionnement satisfaisant, il faut adapter simultanément les valeurs de différents paramètres tels que le nombre d'étages des dispositifs à transfert de charge 2, les fréquences de fonctionnement du registre 1, des dispositifs 2, la vitesse de défilement de l'image.

Dans le cas des figures 1 à 6, l'information provenant du détecteur $A_1$ est transférée dans le dispositif 2 et ré-introduite sur l'entrée $E_2$ en synchronisme avec l'arrivée sur l'entrée $E_1$ de l'information provenant du détecteur $B_1$ correspondant au même point de l'image.

Il y a sommation dans le dispositif 2 des informations provenant des détecteurs $A_1$ et $B_1$. Cette information cumulée est à nouveau transférée dans le dispositif 2, et ré-introduite sur l'entrée $E_2$ en même temps que l'entrée $E_1$ reçoit l'information provenant du détecteur $C_1$ pour un même point de l'image.

Il y a sommation dans le dispositif 2 des informations provenant des détecteurs $A_1$, $B_1$ et $C_1$.

Les informations provenant des détecteurs $A_1$, $B_1$ et $C_1$ se trouvent sommées avec l'information provenant du détecteur $D_1$ pour un même point de l'image qui est injectée directement à la sortie du dispositif sur la diode $d_5$.

On dispose donc d'un signal S, qui est le cumul des informations délivrées par les détecteurs $A_1$, $B_1$, $C_1$ et $D_1$, d'une même ligne pour un même point de l'image. Ce signal S est transmis à l'extérieur du dispositif à transfert de charge 2.

Il est bien entendu que les dispositifs à transfert de charge 2 traitent simultanément les informations des détecteurs d'une même ligne concernant divers points de l'image.

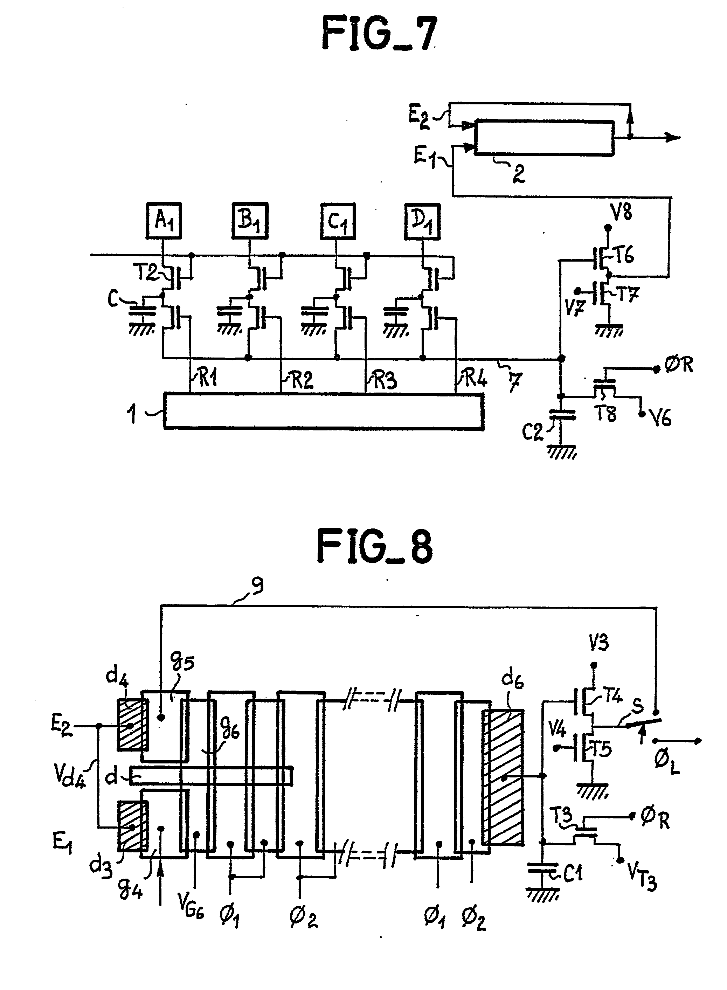

Les figures 7 à 9 illustrent diverses variantes du dispositif précédemment décrit.

La figure 7 représente le schéma d'un mode de réalisation du dispositif selon l'invention.

Ce schéma diffère de celui de la figure 1 notamment parce qu'on n'a représenté qu'une seule ligne de détecteurs $A_1$, $B_1$, $C_1$ et $D_1$, mais aussi parce qu'il comporte deux variantes qui vont être exposées dans ce qui suit.

L'une des variantes consiste à faire transiter par le dispositif à transfert de charge 2 l'information provenant du dernier détecteur $D_1$.

Cette modification amène à modifier le signal de commande $V_{R4}$ qui est représenté sur la figure 9d. Le signal $V_{R4}$ n'est plus confondu avec le signal $V_{R1}$. On voit sur les figures 9a à d que les signaux $V_{R1}$, $V_{R2}$, $V_{R3}$ et $V_{R4}$ passent séquentiellement au niveau haut.

Cette variante conduit à augmenter le nombre d'étages du dispositif à transfert de charge 2 pour que les informations provenant des divers points de l'image ne soient pas confondues dans le registre.

Ainsi par exemple, on peut utiliser des dispositifs à transfert de charge 2 comportant 10 étages lorsque l'information des détecteurs $D_1$, $D_2$, $D_3$... est envoyée directement à la sortie de ces dispositifs. Alors que lorsque l'informtion de ces détecteurs transite dans les dispositifs 2, il faut utiliser 13 étages.

Une autre variante du dispositif de la figure 7 concerne l'interposition d'un étage de lecture des charges entre l'entrée $E_1$ du dispositif à transfert de charge 2 et la connexion 7 qui véhicule séquentiellement l'information provenant des détecteurs d'une même ligne.

Cet étage de lecture comporte une capacité $C_2$ de stockage des charges transmises par la connexion 7. Les charges accumulées sur la capacité $C_2$ sont converties en tension au moyen d'un amplificateur constitué de deux transistors $T_6$ et $T_7$. Ces deux transistors sont par exemple des transistors MOS montés en série. L'entrée se fait sur la grille de $T_6$ qui reçoit sur l'une de ses électrodes une tension de polarisation constante $V_8$. Le transistor $T_7$ est relié à la masse. Sa grille reçoit une tension de polarisation constante $V_7$. C'est le point commun aux transistors $T_6$ et $T_7$ qui constitue la sortie de cet amplificateur reliée à l'entrée $E_1$ du dispositif 2.

Un transistor MOS $T_8$ permet la remise à zéro périodique de la capacité $C_2$. Ce transistor reçoit sur sa grille le signal d'horloge $\emptyset_R$ représenté sur la figure 9g. L'une de ses électrode reçoit une tension de polarisation constante $V_6$ et qui commande aussi le transistor $T_3$ relié à la sortie du dispositif 2.

Sur la figure 8, on a représenté une vue de dessus d'un mode de réalisation sous forme intégrée du dispositif à transfert de charge associé à chaque ligne de détecteurs.

Ce mode de réalisation du dispositif 2 est utilisé dans le cas de la figure 7 où un étage de lecture précède le dispositif 2.

Dans ce cas, les deux entrées $E_1$ et $E_2$ du dispositif 2 sont identiques et semblables à l'entrée $E_2$ du dispositif de la figure 3.

Les entrées $E_1$ et $E_2$ comportent donc deux diodes $d_3$ et $d_4$ qui reçoivent une tension de polarisation $V_{d4}$. Chacune de ces diodes est suivie par une grille $G_4$ et $G_5$. La grille $G_4$ suit la diode $d_3$. Cette grille $G_4$ est reliée à la sortie du dispositif de lecture constitué par les transistors $T_6$ et $T_7$.

La grille $G_5$ suit la diode $d_4$.

Comme dans le cas de la figure 3, cette grille $G_5$ est reliée par la connexion 9 à la sortie du dispositif 2.

Les grilles $G_4$ et $G_5$ sont suivies par une grille $G_6$ portée à une tension constante $V_{G6}$.

Les entrées $E_1$ et $E_2$ ont dans ce mode de réalisation le même type de fonctionnement que celui de l'entrée $E_2$ tel qu'il est exposé sur les figures 6a à 6e.

L'intérêt de ce mode de réalisation est que l'utilisation d'un étage d'amplification avant l'entrée du dispositif 2 permet si l'on utilise un gain inférieur à 1 de diminuer la quantité de charges à véhiculer par les dispositifs 2.

On arrive ainsi à diminuer encore l'encombrement des dispositifs à transfert de charge 2.

Sur les figures 9a à h, on a représenté les signaux d'horloge $V_{R1}$ à $V_{R4}$, puis $\emptyset_1$, $\emptyset_2$, $\emptyset_R$ et $V_{D4}$. Comme cela a été déjà expliqué, le mode de réalisation des figures 7 et 8, entraîne une modification du signal $V_{R4}$ qui n'est plus confondu avec $V_{R1}$.

On a signalé que le dispositif selon l'invention peut être utilisé aussi bien dans le spectre visible que pour détecter un rayonnement infra-rouge.

Dans le cas de la détection du visible, les détecteurs sont des photo-diodes ou/et des photo-MOS. Ces détecteurs sont associés à des moyens de stockage qui peuvent être constitués par les détecteurs eux-mêmes.

Par exemple, pour être utilisé dans le visible le dispositif de la figure 2 doit être modifié.

Les grilles $G_1$ et les diodes $d_1$ sont supprimées. Le reste du dispositif de la figure 2 n'a pas à être modifié.

Les détecteurs peuvent être constitués par des photo-MOS constitués par les grilles $G_2$ ou par des photo-diodes précédant des photo-MOS constitués par les grilles $G_2$ ou seulement par des photo-MOS constitués par les grilles $G_2$.

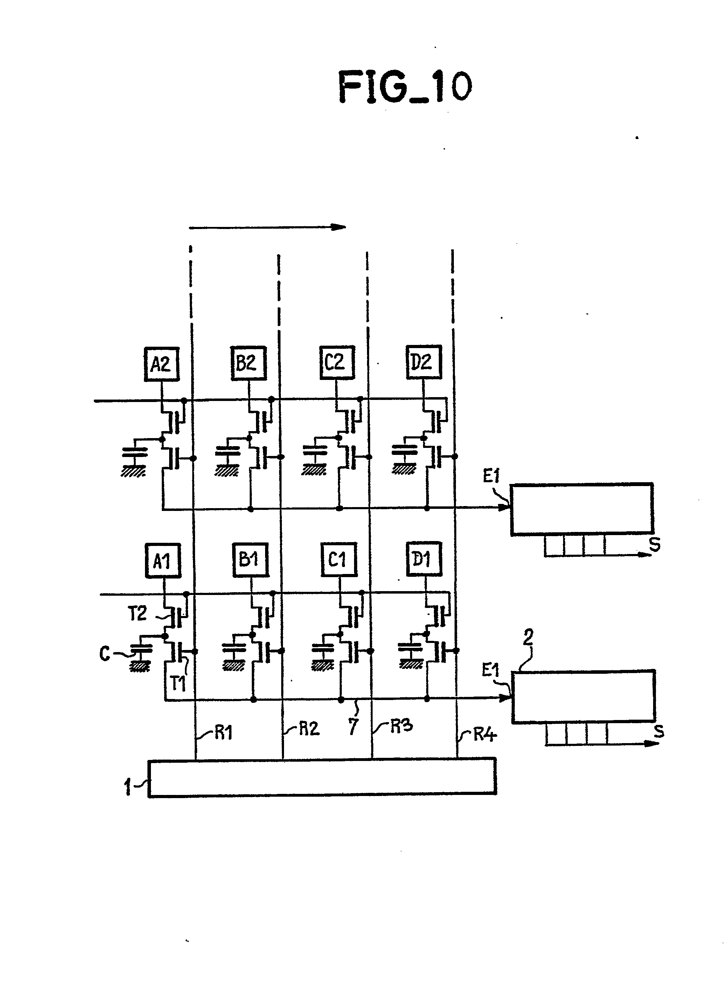

Le mode de réalisation de l'invention qui est représenté sur la figure 10 diffère de celui qui est représenté sur la figure 1 par les points suivants :
- tous les transistors $T_1$ sont reliés entre la borne de chaque capacité $C$ qui n'est pas à la masse et la connexion 7 commune aux détecteurs d'une même ligne et reliée à l'entrée $E_1$ du dispositif à transfert de charge 2 associé à chaque ligne ;
- chaque dispositif à transfert de charge 2 comporte autant de sorties latérales qu'il y a de détecteurs par ligne, soit quatre sorties latérales sur la figure 1 ; la sommation, symbolisée par des conducteurs reliés entre eux, des signaux disponibles sur ces sorties, produit le signal recherché, qui apparaît sur une sortie désignée par la référence S.

Les éléments placés entre les détecteurs et les dispositifs à transfert de charge 2 peuvent être identiques dans les modes de réalisation des figures 1 et 10. Un mode de réalisation de ces éléments est représenté sur la figure 2.

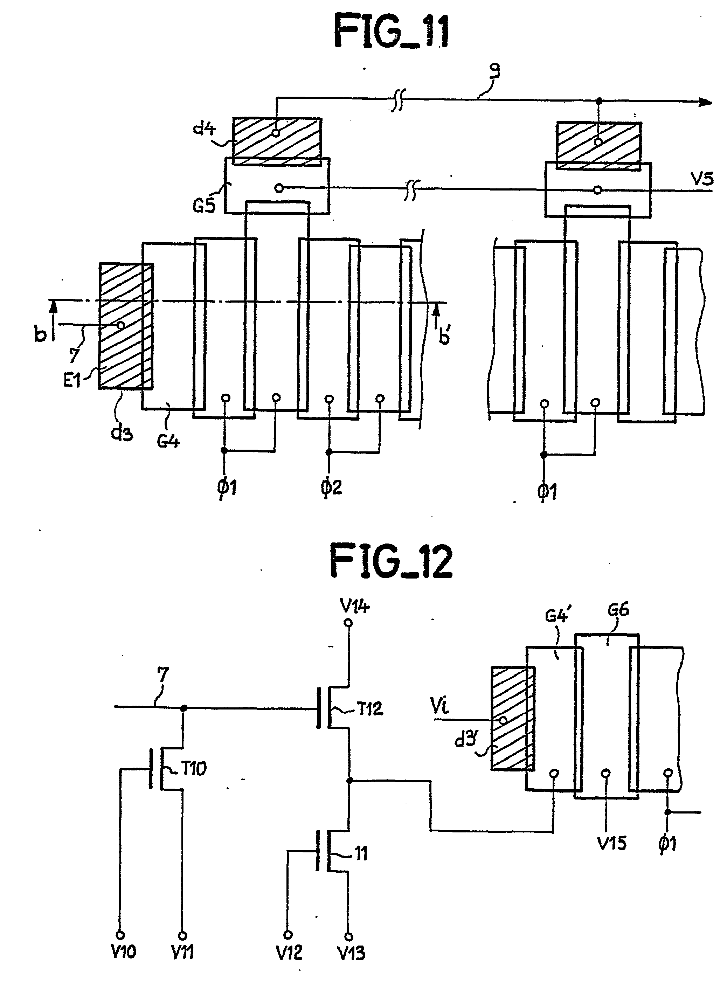

La figure 11 est une vue de dessus d'un mode de réalisation sous forme intégrée du dispositif à transfert de charges associé à chaque ligne de détecteurs dans le mode de réalisation de la figure 10 ; la partie droite de la figure 4a complète cette vue par une vue en coupe selon un axe bb' indiqué sur la figure 11.

L'entrée E1 comporte une diode d3 reliée à la connexion 7 et suivie par une série de grilles de capacités MOS ; la diode d3 est suivie d'une grille G4 portée à un potentiel constant VG4.

Après la grille G4, la structure comporte des couples de grilles recevant des signaux d'horloge en opposition de phase, $\emptyset 1$ et $\emptyset 2$ représentés sur les figures 5e et 5f et dont la fréquence est par exemple de 1MHz.

La figure 11 représente également deux des sorties latérales du dispositif à transfert de charges. Chacune de ces sorties est constituée d'une grille, telle que G5, et d'une diode, telle que d4. Les grilles des différentes sorties sont reliées entre elles et portées à un potentiel V5. Les diodes, telles que d4, sont reliées entre elles par une connexion 9 qui constitue la sortie de signal du circuit à transfert de charges. Le potentiel V5 est représenté sur la figure 5j ; il s'agit de créneaux de tension.

Le fonctionnement du dispositif de la figure 11 est illustré par les figures 4b à 4d qui ont déjà été décrites.

A chaque nouvelle période des signaux $\emptyset 1$ et $\emptyset 2$ les charges provenant du détecteur A1 sont transférées de proche en proche dans le circuit à transfert de charges ; pendant ce transfert les charges provenant du détecteur B1 sont injectées dans l'entrée du circuit à transfert de charge puis transférées à leur tour ; les charges provenant des détecteurs C1 puis D1 sont transférées de la même façon derrière les charges provenant du détecteur B1. Le circuit à transfert de charges contient donc dans ses puits la succession des signaux issus des détecteurs A1, B1, C1 et D1.

Ainsi, quand un point d'image arrive devant le détecteur D1, il a été détecté successivement par les détecteurs A1, B1 et C1 et les signaux correspondants sont présents dans le circuit à transfert de charges. Il suffit alors de lire ces signaux au moyen des sorties latérales et de les additionner pour obtenir le signal de sortie.

Dans l'exemple de chronogramme représenté sur les figures 5a à j, le signal V5 est au niveau haut lorsque le signal $V_{R1}$ et le signal VR4 sont au niveau haut et alors que le signal $\emptyset 1$ est aussi au niveau haut. En conséquence, c'est lorsque les quatre détecteurs d'une ligne ont été lus du fait du passage successif de $V_{R1}$, $V_{R2}$, $V_{R3}$ et $V_{R4}$ au niveau haut, que le signal V5 passe au niveau haut. Le signal de lecture du dernier détecteur de la ligne, D1 par exemple, est transféré sous le couple de grilles qui reçoit le signal $\emptyset 1$ et qui suit immédiatement la

grille G4. Le passage de $V_5$ au niveau haut fait que la grille $G_5$ reliée à ce couple de grilles laisse passer les charges correspondant à la lecture de $D_1$. Le potentiel de la diode d4 correspondante est modifié. Simultanément, les quantités de charges correspondant à la lecture des autres détecteurs de la même ligne, c'est-à-dire des détecteurs $A_1$, $B_1$ et $C_1$, sont transférées à travers les grilles $G_5$ vers les diodes d4. Sur la connexion 9, reliée aux diodes d4, on obtient donc le signal de sortie qui correspond à l'addition des charges provenant des détecteurs $A_1$, $B_1$, $C_1$ et $D_1$.

Le circuit à transfert de charges doit avoir un nombre d'étages suffisant pour stocker toutes ces informations ; le nombre d'étages nécessaire est

$$N(N-1)\frac{t_2}{t_1} + N$$

où est le nombre de détecteurs par ligne, $t_1$ le temps entre deux lectures de l'image par un détecteur, $t_2$ le temps mis par un point d'image pour se déplacer d'un détecteur au suivant.

Par exemple, pour $N = 4$, $t_2/t_1 = 4$, le nombre d'étages du circuit est de 52.

Les sorties latérales du circuit à transfert de charges, au nombre de N, sont positionnées au niveau du premier étage et du dernier étage, les autres étant régulièrement réparties le long du circuit.

Une variante du dispositif de la figure 10 consiste à intercaler entre la connexion, telle que 7, et le circuit à transfert de charges, tel que 2, de chaque ligne, un amplificateur dont le rôle est de convertir les charges électriques en un potentiel. La figure 12 représente un schéma possible d'un tel amplificateur ainsi que de l'étage d'entrée du circuit à transfert de charges.

La figure 12 montre que, dans cette variante, la connexion 7 est reliée à un transistor MOS, T10, servant à la remise à niveau de la connexion 7 et à deux transistors MOS, T11 et T12 montés en amplificateurs suiveurs ; le transistor T10 relie la connexion 7 à une source de tension continue V11 de 10 volts et la tension de commande, V10, de sa grille est une impulsion de remise à zéro ; les transistors T11 et T12 sont montés entre deux sources de tension continue V13 et V14 respectivement de 0 volt et + 15 volts et leurs grilles sont respectivement reliées à une source de tension continue V12 de 0 volt et à la connexion 7, tandis que leur borne commune est reliée à l'entrée d'un circuit à transfert de charges capable de recevoir un signal sous forme d'une tension. Le circuit à transfert de charges, dont une partie seulement est représentée sur la figure 6, comporte une diode d3' suivie par une série de grilles de capacités MOS : G4', puis G6... La grille G4' reçoit le signal du transistor T12 et la diode d3' reçoit un signal Vi formé d'une succession d'impulsions synchronisées avec l'arrivée du signal sur la grille G4' ; la grille G6 est polarisée à un potentiel constant V15 de 5 volts. Le reste du circuit à transfert de charges n'est pas représenté ; il est identique à celui qui est représenté sur la figure 11, à partir des éléments qui, sur cette figure 11 suivent la grille G4.

La variante de la figure 12, grâce à l'amplificateur de gain inférieur à 1, T11-T12, qu'elle met en oeuvre, a l'avantage de permettre de diminuer les dimensions du dispositif à transfert de charges dans les cas où un encombrement minimum est recherché.

## Revendications

1. Dispositif de détection photoélectrique avec retard et intégration en phase, comportant des détecteurs photoélectriques (A1, B1, C1, D1, A2, B2, C2, D2 ...) disposés selon des lignes et des colonnes sur un substrat semiconducteur, des moyens de stockage des charges (C) étant associés à chaque détecteur, et les détecteurs d'une même ligne recevant de façon séquentielle un même point de l'image, des moyens retardant les informations issues des détecteurs d'une même ligne pour les additionner en synchronisme, caractérisé en ce que:
   – un registre à décalage (1) adresse séquentiellement chaque colonne de détecteurs;
   – lesdits moyens retardant les informations sont constitués par un dispositif à transfert de charge (2) associé à chaque ligne de détecteurs, qui reçoit séquentiellement sur une même connexion (7), conformément à l'adressage séquentiel des colonnes par le registre à décalage, les informations stockées par les détecteurs de cette même ligne, ces dispositifs à transfert de charge étant situés en dehors des lignes de détecteurs.

2. Dispositif selon la revendication 1, caractérisé en ce que chaque dispositif à transfert de charge (2) a sa sortie renvoyée vers son entrée (E2) de façon à ré-injecter dans le dispositif l'information précédemment reçue d'un détecteur en phase avec celle reçue du détecteur suivant de la même ligne.

3. Dispositif selon la revendication 2, caractérisé en ce que l'information stockée par les moyens de stockage associés au détecteur (D1, D2, D3 ...) de chaque ligne recevant en dernier chaque point de l'image est envoyée directement à la sortie du dispositif à transfert de charge (2) associé à cette ligne de détecteurs.

4. Dispositif selon la revendication 1, caractérisé en ce que chaque dispositif à transfert de charge (2) comporte des sorties latérales couplées entre elles pour permettre la sommation en synchronisme des signaux d'information reçus.

5. Dispositif selon l'une des revendications 1 à 4, caractérisé en ce que les détecteurs sont des photodiodes (A1, B1, C1 ... A2, B2, C2 ...), chaque photodiode étant reliée à une première diode (d1), et ladite connexion (7) avec le dispositif à transfert de charge de la ligne correspondante étant reliée à une deuxième diode (d2), avec entre les deux diodes un espace semiconducteur surmonté de plusieurs grilles adjacentes (G1, G2, G3) dont l'une (G3) est commandée par le registre à décalage.

6. Dispositif selon l'une des revendications 1 à 4, caractérisé en ce qu'il est utilisé pour la détection d'un rayonnement visible et en ce que les détecteurs sont des photodiodes ou/et des photo-MOS, chaque détecteur étant relié à une grille (G2) elle-même adjacente à une grille (G3) commandée par le registre à décalage.

7. Dispositif selon l'une des revendications 1 à 6, caractérisé en ce que chaque dispositif à transfert de charge (2) comporte une première et une seconde entrée (E1 et E2), la première entrée (E1) étant reliée à ladite connexion (7) et la seconde entrée (E2) recevant la tension de sortie de ce dispositif.

8. Dispositif selon la revendication 7, caractérisé en ce qu'un étage de lecture des charges (T6, T7) est intercalé entre ladite connexion (7) et le dispositif à transfert de charge (2) associé à chaque ligne de détecteurs.

9. Dispositif selon l'une des revendications 7 ou 8, caractérisé en ce que la première entrée (E1) comporte une diode (d3) intégrée dans le substrat semiconducteur (4) et reliée à ladite connexion (7) et la seconde entrée (E2) comporte une diode (d4) recevant une tension pulsée (Vd4), cette diode étant adjacente à une grille (G5) qui reçoit la tension de sortie du dispositif et qui est elle-même adjacente à une autre grille (G6) qui reçoit une tension de polarisation constante.

10. Dispositif selon l'une des revendications 1 à 6, caractérisé en ce que chaque dispositif à transfert de charge comporte une première et une deuxième entrées (E1, E2), chacune associée à une diode respective (d3, d4) adjacentes chacune à une grille respective (G4, G5), ces deux entrées recevant une même tension pulsée (Vd4), une des grilles (G4) étant reliée à la sortie d'un étage de lecture de charges dont l'entrée est reliée à ladite connexion (7), l'autre grille (G5) recevant la sortie du dispositif à transfert de charges, une troisième grille (G6), adjacente aux deux premières, recevant une tension de polarisation constante (VG6).

11. Dispositif selon la revendication 4 ou une quelconque des revendications 5 à 10 prise en combinaison avec la revendication 4, caractérisé en ce qu'un atténuateur de gain inférieur à 1 est interposé entre ladite connexion (7) et le dispositif à transfert de charges.

## Claims

1. A photoelectric detection device with time delay and inphase integration, comprising photoelectric detectors (A1, B1, C1, D1, A2, B2, C2, D2 ...) disposed along lines and columns of a semiconductor substrate, charge storing means (C) associated with each detector, the detectors of a same line receiving sequentially a same image point, and means for delaying the information issued by the detectors of a same line in view of their synchronous addition, characterized in that

— a shift register (1) addresses each detector column sequentially and

— said information delaying means are constituted by a charge transfer device (2) associated with each detector line and receiving sequentially, over a same connexion (7) and in conformity with the sequential addressing of the columns by the shift register, the information stored by the detectors of this very line, these charge transfer devices being disposed outside the detector lines.

2. A device according to claim 1, characterized in that each charge transfer device (2) has its output fed back to its input (E2), so as to reinject into the device, in phase with an information received by the following detector of the same line, the information received previously by a detector.

3. A device according to claim 2, characterized in that the information received by the storage means associated with the detector (D1, D2, D3 ...) of each line which receives each image point last is passed directly to the output of the charge transfer device (2) associated with this detector line.

4. A device according to claim 1, characterized in that each charge transfer device (2) comprises side outputs which are mutually coupled in order to allow for summing up the received information signals synchronously.

5. A device according to anyone of claims 1 to 4, characterized in that the detectors consist of photodiodes (A1, B1, C1 ... A2, B2, C2 ...), each photodiode being connected to a first diode (d1), and said connexion (7) with the charge transfer device of the corresponding line being connected to a second diode (d2), a semiconducting space being provided between the diodes, which is crossed by several adjacent gates (G1, G2, G3), of which one (G3) is controlled by the shift register.

6. A device according to one of the claims 1 to 4, characterized in that it is used for the detection of visible radiation, and that the detectors are constituted of photodiodes or/and photo-MOS-devices, each detector being connected to a gate (G2) which is adjacent to a gate (G3) controlled by the shift register.

7. A device according to one of the claims 1 to 6, characterized in that each charge transfer device (2) comprises a first and a second input (E1 and E2), the first input (E1) being connected to said connexion (7) and the second input (E2) receiving the output voltage of this device.

8. A device according to claim 7, characterized in that a charge reading stage (T6, T7) is inserted between said connexion (7) and the charge transfer device (2) associated with each line of detectors.

9. A device according to claim 7 or 8, characterized in that the first input (EI) comprises a diode (d3) integrated in the semiconducting substrate (4) and connected to said connexion (7), and the second input (E2) comprises a diode (d4) receiving a pulsed voltage (Vd4), said diode being adjacent to a gate (G5) which receives the output voltage of the device and which is itself adjacent to another gate (G6) which receives a constant biassing voltage.

10. A device according to one of the claims 1 to 6, characterized in that each charge transfer device comprises a first and a second input (E1, E2), each associated with a respective diode (d3, d4) disposed adjacent to a respective gate (G4, G5), said two inputs receiving a same pulsed voltage (Vd4) and one of the gates (G4) being connected to the output of a charge reading stage, whose input is connected to said connexion (7), while the other gate (G5) receives the output signal of the charge transfer device, a third gate (G6) adjacent to said two first gates receiving a constant biassing voltage (VG6).

11. A device according to claim 4 or to anyone of the claims 5 to 10 in combination with claim 4, characterized in that an attenuator having a gain less then 1 is interposed between said connexion (7) and the charge transfer device.

**Patentansprüche**

1. Fotoelektrische Detektoreinrichtung, die mit Zeitverzögerung und Phasenintegration arbeitet, mit zeilen- und spaltenmäßig auf einem Halbleitersubstrat angeordneten Fotodetektoren (A1, B1, C1, D1, A2, B2, C2, D2...), wobei Ladungsspeichermittel (C) jedem Detektor zugeordnet sind und die Detektoren einer gemeinsamen Zeile nacheinander denselben Bildpunkt empfangen, und mit Mitteln zur Verzögerung der von den Detektoren einer gemeinsamen Zeile gelieferten Information, um sie synchron zu addieren, dadurch gekennzeichnet, daß
   – ein Schieberegister (1) nacheinander jede Detektorspalte adressiert, und
   – die Mittel zur Verzögerung der Informationen aus einer jeder Detektorzeile zugeordneten Ladungstransfereinrichtung (2) bestehen, die nacheinander über einen gemeinsamen Anschluß (7) die von den Detektoren dieser Zeile gespeicherten Informationen entsprechend der durch das Schieberegister nacheinander erfolgenden Adressierung der Spalten zugeführt erhält, wobei diese Ladungstransfereinrichtungen außerhalb der Detektorzeilen angeordnet sind.

2. Einrichtung nach Anspruch 1, dadurch gekennzeichnet, daß bei jeder Ladungstransfereinrichtung (2) der Ausgang auf den Eingang rückgekoppelt ist (E2), derart, daß die zuvor von einem Detektor empfangene Information, die phasengleich mit dem vom nachfolgenden Detektor empfangenen Information ist, wieder in die Einrichtung eingegeben wird.

3. Einrichtung nach Anspruch 2, dadurch gekennzeichnet, daß die von den Speichermitteln, welche dem Detektor (D1, D2, D3, ...) jeder Zeile zugeordnet sind, der als letzter jeden Bildpunkt zugeführt erhält, gespeicherte Information unmittelbar an den Ausgang der mit dieser Detektorzeile verbundenen Ladungstransfereinrichtung (2) gegeben wird.

4. Einrichtung nach Anspruch 1, dadurch gekennzeichnet, daß jede Ladungstransfereinrichtung (2) miteinander gekoppelte Seiteneingänge für die synchrone Summenbildung der empfangenen Informationssignale besitzt.

5. Einrichtung nach einem der Ansprüche 1 bis 4, dadurch gekennzeichnet, daß die Detektoren aus Fotodioden (A1, B1, C1 ... A2, B2, C2 ...) bestehen, wobei jede Fotodiode mit einer ersten Diode (d1) verbunden ist und wobei der Anschluß (7) zur Ladungstransfereinrichtung der entsprechenden Zeile mit einer zweiten Diode (d2) verbunden ist, unter Belassung eines halbleitenden Raumes zwischen den beiden Dioden, der von mehreren benachbarten Gittern (G1, G2, G3) überquert wird, wovon eines (G3) durch das Schieberegister gesteuert wird.

6. Einrichtung nach einem der Ansprüche 1 bis 4, dadurch gekennzeichnet, daß sie zur Erfassung einer sichtbaren Strahlung verwendet wird und daß die Detektoren aus Fotodioden oder/und aus Foto-MOS-Elementen bestehen, wobei jeder Detektor mit einem Gitter (G2) verbunden ist, das seinerseits einem vom Schieberegister gesteuerten Gitter (G3) benachbart ist.

7. Einrichtung nach einem der Ansprüche 1 bis 6, dadurch gekennzeichnet, daß jede Ladungstransfereinrichtung (2) einen ersten und einen zweiten Eingang (E1 und E2) aufweist, wobei der erste Eingang (E1) mit dem Anschluß (7) verbunden ist und der zweite Eingang (E2) die Ausgangsspannung dieser Einrichtung zugeführt erhält.

8. Einrichtung nach Anspruch 7, dadurch gekennzeichnet, daß eine Stufe zum Auslesen der Ladungen (T6, T7) zwischen den Anschluß (7) und die jeder Detektorzeile zugeordnete Ladungstransfereinrichtung (2) eingefügt ist.

9. Einrichtung nach Anspruch 7 oder 8, dadurch gekennzeichnet, daß der erste Eingang (E1) eine in das Halbleitersubstrat (4) integrierte und an den Anschluß (7) angeschlossene Diode (d3) und der zweite Eingang (E2) eine eine gepulste Spannung (Vd4) empfangende Diode (d4) aufweist, wobei diese Diode einem Gitter (G5) benachbart ist, das die Ausgangsspannung der Einrichtung empfängt und das selber einem weiteren Gitter (G6) benachbart ist, welchem eine konstante Vorspannung zugeführt wird erhält.

10. Einrichtung nach einem der Ansprüche 1 bis 6, dadurch gekennzeichnet, daß jede Ladungstransfereinrichtung einen ersten und einen zweiten Eingang (E1, E2) aufweist, die je einer je einem Gitter (G4, G5) benachbarten Diode (d3, d4) zugeordnet sind, wobei den beiden Eingängen die gleiche gepulste Spannung (Vd4) zugeführt wird und eines der Gitter (G4) an den Ausgang einer Ladungslesestufe angeschlossen ist, deren Eingang mit dem Anschluß (7) verbunden ist, während dem anderen Gitter (G5) das Ausgangssignal der Ladungstransfereinrichtung zugeführt wird, und wobei ein drittes, den beiden ersten benachbartes Gitter (G6) eine konstante Vorspannung (VG6) zugeführt erhält.

11. Vorrichtung nach Anspruch 4 oder nach einem der Ansprüche 5 bis 10 in Verbindung mit Anspruch 4, dadurch gekennzeichnet, daß ein Dämpfungsglied mit einem Gewinn unter 1 zwischen den Anschluß (7) und die Ladungstransfereinrichtung eingefügt ist.

# FIG_1

# FIG_2

# FIG_3

# FIG_4-a

## FIG_4-b

## FIG_4-c

## FIG_4-d

FIG_5-a $V_{R1}$

FIG_5-b $V_{R2}$

FIG_5-c $V_{R3}$

FIG_5-d $V_{R4}$

FIG_5-e $\varnothing 1$

FIG_5-f $\varnothing 2$

FIG_5-g $\varnothing R$

FIG_5-h $\varnothing L$

FIG_5-i $V_{d4}$

FIG_5-j $V_5$

EP 0 207 826 B1

COUPE c–c'

FIG_6–a

FIG_6–b

FIG_6–c

FIG_6–d

FIG_6–e

## FIG_7

## FIG_8

FIG_9-a $V_{R1}$

FIG_9-b $V_{R2}$

FIG_9-c $V_{R3}$

FIG_9-d $V_{R4}$

FIG_9-e $\emptyset 1$

FIG_9-f $\emptyset 2$

FIG_9-g $\emptyset R$

FIG_9-h $V_{D4}$

# FIG_10

# FIG_11

# FIG_12